# EUROPEAN PATENT APPLICATION

(11) **EP 4 700 823 A1**
(43) Date of publication of application: **25.02.2026**
(21) Application number: 24792572.0
(22) Date of filing: 10.04.2024
(51) Int. Cl.: H01L 21/52, C09J 9/02, C09J 11/04, H01B 1/00, H01B 1/20, H01B 1/22, H01B 13/00, H01L 21/60, H05K 3/38

(54) **SILVER OXIDE PARTICLES, SILVER OXIDE POWDER, BONDING COMPOSITION, SILVER OXIDE PASTE, METHOD FOR PRODUCING SEMICONDUCTOR DEVICE USING SAID BONDING COMPOSITION OR SAID SILVER OXIDE PASTE, AND METHOD FOR PRODUCING SILVER OXIDE PARTICLES OR SILVER OXIDE POWDER**

(30) Priority: 17.04.2023 JP 2023067078; 10.10.2023 JP 2023175174
(71) Applicant: Central Glass Company, Limited, Ube-shi, Yamaguchi 755-0001 (JP)
(72) Inventor: HAMADA, Jun, Tokyo 101-0054 (JP); KIDA, Takahisa, Tokyo 101-0054 (JP); NAITO, Takuma, Tokyo 101-0054 (JP); HASHIMOTO, Kosuke, Tokyo 101-0054 (JP); TAKASAKI, Mikihiro, Tokyo 101-0054 (JP)
(74) Representative: Mewburn Ellis LLP
(86) International application number: PCT/JP2024/014464
(87) International publication number: WO 2024/219297

(57) **Abstract**

The present invention provides a bonding material that achieves good bonding strength even when bonding at low temperatures. Flake-shaped silver oxide particles or a silver oxide powder containing the particles are provided. The flake-shaped silver oxide particles have an average thickness of 10 to 100 nm and a D50 of 100 to 350 nm. Moreover, the flake-shaped silver oxide particles or silver oxide powder containing the particles may be used as a paste for bonding a semiconductor substrate with, for example, a power semiconductor chip.

## Description

### TECHNICAL FIELD

The present disclosure relates to a silver oxide paste and a method for producing semiconductor devices using the silver oxide paste.

### BACKGROUND ART

Conventionally, power semiconductor devices have been used in power control and motor control for automobiles, power transmission systems, railways, solar cells, home appliances, etc. Until now, Si-based semiconductor devices using Si have been in the mainstream. However, due to a demand for higher currents and voltages, power semiconductor devices using SiC, GaN, etc. have been studied.

The operating temperature of power semiconductor devices is expected to reach 200°C or more, which is higher than the operating temperature of the Si-based semiconductor devices mainly used currently. Accordingly, there exists a problem that the conventional bonding materials such as solder alloys and epoxy-based conductive adhesives cannot withstand the operating temperature.

In recent years, silver-based bonding materials such as silver and silver oxide have been proposed for use as bonding materials having resistance to high temperatures of 200°C or more, low electrical resistance, and high heat dissipation characteristics.

Patent Literature 1 discloses that using silver oxide particles as a material for bonding a semiconductor element to a circuit layer in a power module enables the bonding temperature to the semiconductor element to be kept low, thereby reducing the thermal load on the semiconductor element. Patent Literature 1 also discloses 0.1 µm to 40 µm silver oxide particles as the silver oxide particles, and the micron-sized silver oxide particles have been verified in the examples. Such fine silver oxide particles are usually obtained by precipitation from a silver salt solution and generally have a relatively isotropic shape, such as a spherical or nearly spherical shape.

### CITATION LIST

### - Patent Literature

Patent Literature 1: JP 2014-96545 A

### SUMMARY OF THE INVENTION

### - Technical Problem

It has been found that the proposed bonding material composed of silver oxide particles having a spherical shape may exhibit insufficient bonding strength for bonding at a relatively low temperature of, for example, about 250°C, thereby requiring improvement for practical use. A problem to be solved by the present disclosure is to provide a bonding material, such as silver oxide paste, that achieves good bonding strength even when bonding at low temperatures.

### - Solution to Problem

The present inventors have focused on nano-sizing silver oxide particles, and found that forming silver oxide particles into a flake shape enables a bonding material that provides good bonding strength without causing cracking or peeling due to thermal shrinkage.

Specifically, one aspect of the present disclosure relates to flake-shaped silver oxide particles having a nano-sized thickness or a silver oxide powder containing the particles.

The present disclosure is as follows.

Embodiment (1-1) of the present disclosure relates to flake-shaped silver oxide particles or a silver oxide powder containing the particles, the flake-shaped silver oxide particles having an average thickness of 1 to 100 nm and a D50 of 100 to 350 nm.

Embodiment (1-2) of the present disclosure relates to the flake-shaped silver oxide particles or silver oxide powder containing the particles according to Embodiment (1-1), wherein the flake-shaped silver oxide particles have an average major axis of 300 to 1000 nm.

Embodiment (1-3) of the present disclosure relates to the flake-shaped silver oxide particles or silver oxide powder containing the particles according to Embodiment (1-1) or (1-2), wherein a half width of a diffraction peak from a (111) plane in an X-ray diffraction spectrum of the flake-shaped silver oxide particles is 0.80 or more.

Embodiment (1-4) of the present disclosure relates to the flake-shaped silver oxide particles or silver oxide powder containing the particles according to any one of Embodiments (1-1) to (1-3), wherein at least some of the flake-shaped silver oxide particles have, on their surfaces, a compound having a glycol ether skeleton in a main chain, a side chain, or both.

Embodiment (1-5) of the present disclosure relates to a bonding composition, containing:
the flake-shaped silver oxide particles or silver oxide powder containing the particles according to any one of Embodiments (1-1) to (1-4);
a dispersant; and
a dispersion medium.

Embodiment (1-6) of the present disclosure relates to the bonding composition according to Embodiment (1-5), wherein the dispersant is a compound having a glycol ether skeleton in a main chain, a side chain, or both.

Embodiment (1-7) of the present disclosure relates to the bonding composition according to Embodiment (1-5) or (1-6), wherein the dispersion medium is a compound having an ethylene-based or propylene-based glycol ether skeleton.

Embodiment (1-8) of the present disclosure relates to a method for producing the flake-shaped silver oxide particles or silver oxide powder containing the particles according to any one of Embodiments (1-1) to (1-4), the method including subjecting silver oxide particles to bead mill grinding.

Embodiment (1-9) of the present disclosure relates to the method for producing the flake-shaped silver oxide particles or silver oxide powder containing the particles according to Embodiment (1-8), wherein the bead mill grinding includes:
supplying the silver oxide particles, the dispersant, and the dispersion medium to a bead mill grinding device; and
performing bead mill grinding in the device to obtain a slurry containing the flake-shaped silver oxide particles.

Embodiment (1-10) of the present disclosure relates to the method for producing the flake-shaped silver oxide particles or silver oxide powder containing the particles according to Embodiment (1-8) or (1-9), wherein the dispersant is a compound having a glycol ether skeleton in a main chain, a side chain, or both.

Embodiment (1-11) of the present disclosure relates to a method for producing a semiconductor device, including:
(1) applying the bonding composition according to any one of Embodiments (1-5) to (1-7) onto a semiconductor substrate to form a layer of the bonding composition;
(2) placing a semiconductor chip on the layer of the bonding composition to form a stack; and
(3) heating the resulting stack at 300°C or less while applying a pressure of 0 to 30 MPa to integrate the stack.

Embodiment (1-12) of the present disclosure relates to the method for producing a semiconductor device according to Embodiment (1-11), further including, between the steps (1) and (2), drying the layer of the bonding composition.

Embodiment (1-13) of the present disclosure relates to the method for producing a semiconductor device according to Embodiment (1-11) or (1-12), wherein the semiconductor chip is an SiC semiconductor chip.

Embodiment (2-1) of the present disclosure relates to a silver oxide paste, containing:
flake-shaped silver oxide particles;
a dispersant; and
a dispersion medium,
wherein the silver oxide particles have an average thickness of 1 to 100 nm and a D50 of 100 to 350 nm.

Embodiment (2-2) of the present disclosure relates to the silver oxide paste according to Embodiment (2-1), further containing a protonic additive.

Embodiment (2-3) of the present disclosure relates to the silver oxide paste according to Embodiment (2-1) or (2-2), wherein the dispersant is a compound having a glycol ether skeleton in a main chain, a side chain, or both.

Embodiment (2-4) of the present disclosure relates to the silver oxide paste according to any one of Embodiments (2-1) to (2-3), wherein the dispersion medium is a compound having an ethylene-based or propylene-based glycol ether skeleton.

Embodiment (2-5) of the present disclosure relates to the silver oxide paste according to any one of Embodiments (2-1) to (2-4), wherein the silver oxide particles have an average major axis of 300 to 1000 nm.

Embodiment (2-6) of the present disclosure relates to the silver oxide paste according to any one of Embodiments (2-1) to (2-5), wherein a half width of a diffraction peak from a (111) plane in an X-ray diffraction spectrum of the silver oxide particles is 0.80 or more.

Embodiment (2-7) of the present disclosure relates to a silver oxide paste according to any one of Embodiments (2-1) to (2-6), wherein an amount of the dispersant is 12 mass% or less based on a total mass of the silver oxide paste.

Embodiment (2-8) of the present disclosure relates to the silver oxide paste according to Embodiment (2-2), wherein an amount of the protonic additive is 0.5 to 10 mass% based on a total mass of the silver oxide paste.

Embodiment (2-9) of the present disclosure relates to the silver oxide paste according to any one of Embodiments (2-1) to (2-8) for use in a bonding application.

Embodiment (2-10) of the present disclosure relates to a method for producing a semiconductor device, including:
(1) applying the silver oxide paste according to any one of Embodiments (2-1) to (2-9) onto a first substrate to form a layer of the silver oxide paste;
(2) placing a second substrate on the layer of the silver oxide paste to form a stack; and
(3) heating the resulting stack at 300°C or less while applying a pressure of 0 to 30 MPa to integrate the stack.

Embodiment (2-11) of the present disclosure relates to the method for producing a semiconductor device according to Embodiment (2-10), further including, between the steps (1) and (2), drying the layer of the silver oxide paste.

Embodiment (2-12) of the present disclosure relates to the method for producing a semiconductor device according to Embodiment (2-10) or (2-11), wherein the second substrate is a semiconductor chip.

### - Advantageous Effects of Invention

The present disclosure provides a bonding material, such as silver oxide paste, that achieves good bonding strength even when bonding at low temperatures.

### BRIEF DESCRIPTION OF DRAWINGS

[FIG. 1] FIG. 1 shows a diagram showing a method for bonding a power semiconductor using a paste as a composition containing flake-shaped silver oxide particles according to the present disclosure.

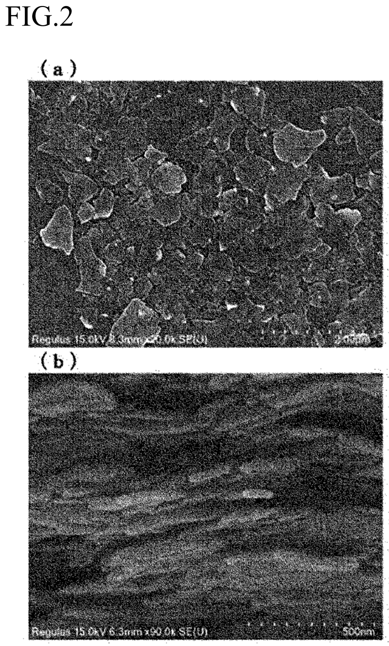

[FIG. 2] FIG. 2 shows electron microscopic photographs used for measuring the average major axis (a) and the average thickness (b) of the flake-shaped silver oxide particles.
[FIG. 3] FIG. 3 shows a drawing-substitute photograph of the raw material silver oxide particles (before dispersion) used in Comparative Examples 2 to 5.
[FIG. 4] FIG. 4 shows drawing-substitute photographs showing cross-sections of the bonding layers in Example 3 (a) and Comparative Example 6 (b).
[FIG. 5] FIG. 5 shows a drawing-substitute photograph showing a cross-section of the bonding layer in Example 3.

### DESCRIPTION OF EMBODIMENTS

The present disclosure is described in detail below. The descriptions of the constituent features provided below illustrate exemplary embodiments of the present disclosure, and the present disclosure is not limited to these specific contents. Various modifications can be made for implementation within the scope of the gist of the disclosure.

In the present specification, the expression "X to Y" used to describe a numerical range means X or more and Y or less, unless otherwise specified. For example, "1 to 5 mass%" means "1 mass% or more and 5 mass% or less".

A silver oxide paste according to the present disclosure contains:
flake-shaped silver oxide particles,
a dispersant, and
a dispersion medium, and
the silver oxide particles have an average thickness of 1 to 100 nm and a D50 of 100 to 350 nm.

Such a silver oxide paste achieves good bonding strength even when bonding at low temperatures (for example, at 250°C).

The present disclosure is described in detail below.

### (Flake-shaped silver oxide particles and silver oxide powder)

In the present disclosure, flake-shaped silver oxide particles constituting a silver oxide powder do not mean individual flake-shaped silver oxide particles, but mean flake-shaped silver oxide particles as an aggregate or a flake-shaped group of silver oxide particles.

A silver oxide powder according to the present disclosure is characterized by containing flake-shaped silver oxide particles which have an average of the thicknesses (average thickness) of 1 to 100 nm, and a D50 of 100 to 350 nm. Note that "flake-shaped silver oxide particles" refer to silver oxide particles having a flake shape with an average thickness and D50 within the ranges indicated above.

Through investigation by the present inventors, it has been found that using the flake-shaped silver oxide particles instead of conventionally used spherical silver oxide particles provides good bonding strength even at low temperatures.

In one aspect of the present disclosure, the investigation by the inventors have also revealed that the flake-shaped silver oxide particles having a smaller particle size are more easily reduced at a low temperature range of 250°C or less, whereas they shrink more when heated, resulting in a higher occurrence of cracks, peeling, or other defects. Furthermore, it has been found that the shrinkage can also result from the desorption of oxygen due to the reduction of silver oxide, and tends to occur more readily when using silver oxide particles than when using silver particles. On the other hand, as the particle size increases, cracks, peeling, and other defects are less likely to occur, but the reduction in the low temperature range tends to be more difficult. One aspect of the present disclosure is that forming silver oxide particles into a flake shape enables both ease of reduction and suppression of cracking or peeling.

The silver oxide powder of the present disclosure may also contain non-flake-shaped silver oxide particles within a range that does not adversely affect various properties. The amount of such silver oxide particles is not particularly limited, and may be, for example, 30 mass% or less based on 100 mass% of the silver oxide powder.

The term "flake-shaped" refers to a structure that is non-spherical, and has at least an upper surface, a lower surface, and a thickness, with the upper and lower surfaces being substantially flat. Here, the upper and lower surfaces may be partially uneven or deformed, and, when viewed as a whole, the shape may be a flat plate or a rectangular parallelepiped having a small thickness (i.e., a thickness smaller than the length). The term may also refer to a flat plate-like shape, such as a thin slice or a scale (flaky shape: "plate-like shape" described in JIS Z2500:2000).

More specifically, according to the method for measuring the average thickness described later, a sample that can be observed from the cross-sectional direction of silver oxide particles is prepared and observed under a scanning electron microscope. When the distance between the upper and lower surfaces of the central part of a particle is taken as the thickness of the particle, the particle may be determined to have a flake shape if the length of the side intersecting the thickness direction of the particle is greater than the defined thickness.

Adjusting the average thickness of the flake-shaped silver oxide particles to 1 to 100 nm enables good reducibility (particularly during bonding) at 250°C or less, resulting in a bonding strength of 30 MPa or more. The average thickness may also preferably be 5 to 90 nm, more preferably 10 to 50 nm, still more preferably 15 to 40 nm.

The D50 of the flake-shaped silver oxide particles indicates the median diameter (median value) when individual particles are regarded as spheres. Adjusting the D50 to 100 to 350 nm enables good bonding strength. It has also been found that the silver oxide particles tend to exhibit cracking or peeling more easily at the bonding part due to thermal shrinkage as the particle size decreases. On the other hand, adjusting the D50 to 100 to 350 nm enables both suppression of cracking or peeling at the bonding part and good bonding strength. From the standpoint of facilitating the suppression of cracking or peeling at the bonding part, the D50 may be suitably 180 to 350 nm, more preferably 200 to 320 nm. Here, cracking or peeling due to thermal shrinkage can occur at each of the process steps involving heating, such as the reduction of silver oxide, and the drying, sintering, and bonding of the silver oxide paste (hereinafter also referred to simply as paste) described later. In particular, a D50 of 200 nm or more is suitable because it facilitates the suppression of cracking or peeling during the reduction of silver oxide or the drying of the paste, even in the absence of components (such as plasticizers as described later) that aid in suppressing such cracking or peeling.

From another standpoint, the average of the major axes (average major axis) of the flake-shaped silver oxide particles may be, for example, 300 to 1000 nm, preferably 300 to 900 nm, more preferably 300 to 700 nm, still more preferably 400 to 700 nm. An average major axis within the above range is suitable from the standpoint of suppressing cracking or peeling at the bonding part.

Moreover, from still another standpoint, the average of the major axes (average major axis) of the flake-shaped silver oxide particles is suitably, for example, 300 to 1000 nm, and is more suitably 400 to 900 nm from the standpoint of suppressing cracking or peeling at the bonding part.

From another standpoint, the half width of the diffraction peak from the (111) plane of silver oxide in the X-ray diffraction spectrum of the flake-shaped silver oxide particles is suitably 0.80 or more and may be more preferably 0.85 or more. The upper limit is not particularly limited, and may be, for example, 1.20 or less, preferably 1.12 or less. Moreover, the (111) plane of silver oxide has a main peak at 32° to 33°.

A half width within the above range is suitable because the bonding strength tends to be improved more easily compared to when using spherical silver oxide particles having a comparable D50. This is presumably because, with a half width of 0.80 or more, the crystallinity of silver oxide is considered low, resulting in a lower bonding force of the Ag-O bonds constituting the crystal, and therefore reduction can occur more easily at a lower temperature. The decrease in the crystallinity of silver oxide is presumably caused by the grinding described later. It is presumed that when raw material silver oxide particles are ground, they can be downsized to a certain extent, but if they have been micronized to the limit, they can no longer be broken and instead undergo plastic deformation into a flake shape. This plastic deformation is presumed to decrease the crystallinity.

It is also suitable that the aspect ratio (l/t) of the average major axis (l) to the average thickness (t) is usually 8 to 20, preferably 14 to 18, from the standpoint of suppressing cracking or peeling at the bonding part. The aspect ratio may be calculated from the average thickness and average major axis of the flake-shaped silver oxide particles.

It is also suitable that at least some of the flake-shaped silver oxide particles contained in the silver oxide powder have, on their surfaces, a compound having a glycol ether skeleton in the main chain and/or side chain, because this facilitates reduction at low temperatures. The compound is as described as the dispersant in the composition described later. Moreover, the expression "having, on their surfaces" refers to the compound being attached to the surfaces of the flake-shaped silver oxide particles through chemical bonding, physical adsorption, or the like. Moreover, the compound is more preferably attached to all the flake-shaped silver oxide particles constituting the silver oxide powder.

It should be noted that the shape identification, D50, average thickness, average major axis, and XRD half width of the particles can be determined or measured by the measurement methods described in detail later, respectively.

### (Method for producing flake-shaped silver oxide particles)

The flake-shaped silver oxide particles of the present disclosure can be obtained, for example, by subjecting commercially available silver oxide particles (generally having a spherical or nearly spherical shape with a particle size of about 1 to 20 µm) as raw material to grinding with a bead milling device. Usually, silver oxide particles having a microparticle size or less are spherical particles obtained by precipitation from a silver salt solution, as disclosed in JP 2005-104825 A. In contrast, the silver oxide particles of the present disclosure have been formed into a flake shape by grinding with a bead milling device.

In grinding with a bead milling device, silver oxide particles as raw material (raw material silver oxide particles) may be introduced into a grinding chamber in the bead milling device together with a dispersant for suppressing particle aggregation and a dispersion medium, and the stirring mechanism (rotor) may then be rotated at high speed (high peripheral speed) so that the beads serving as grinding media in the grinding chamber collide with the raw material silver oxide particles, thereby grinding them.

As the dispersant to be used, any dispersant can be used without particular limitation as long as it can disperse the raw material silver oxide particles, the silver oxide particles during grinding, and the flake-shaped silver oxide particles after grinding in a dispersion medium, without particularly affecting the physical properties or other characteristics of the raw material silver oxide particles. Moreover, the dispersant usually adheres to the surfaces of at least some of the flake-shaped silver oxide particles and remains even after separation and drying of the solids, as described later, thereby preventing the flake-shaped silver oxide particles from aggregating with strong force. Examples of such dispersants include commercially available dispersants such as polyacrylate, aliphatic, polyester, polyurethane, and polyether dispersants. The dispersants may be used alone or in combination of two or more. Moreover, the dispersant may also suitably be a compound having a glycol ether skeleton in the main chain and/or side chain, which will be described later.

The dispersion medium used is a medium that causes no reaction (e.g., reduction reaction) with silver oxide, because strong energy is applied to the raw material silver oxide particles during grinding with beads. Further, any dispersion medium can be used without particular limitation as long as it can keep the raw material silver oxide particles, the silver oxide particles during grinding, and the flake-shaped silver oxide particles after grinding in a dispersed state. Examples of such dispersion media include water. The dispersion media may be used alone or in combination of two or more.

As the grinding media (beads) used, any type of bead conventionally used in the field of bead mill grinding can be used without particular limitation. Examples of such beads include beads made of materials such as glass, zirconia, alumina, silica and steel. These may be used alone or in combination of two or more. Since beads that are too large or too small in size are likely to be ground insufficiently, it is desirable to use beads with a diameter of 0.01 to 0.5 mm. Beads within the above range can produce flake-shaped silver oxide particles having the desired size and shape.

Moreover, the average thickness, D50 value, and average major axis of the intended flake-shaped silver oxide particles may be adjusted by appropriately adjusting the grinding time, rotor peripheral speed, bead filling factor, and other conditions of the bead milling device. The grinding time may be, for example, about 100 to 500 minutes, depending on the size of the desired flaky silver oxide powder. As the grinding time increases, grinding proceeds, resulting in a tendency for the D50 value to decrease. Moreover, the rotor peripheral speed is suitably, for example, about 5 to 20 m/s, and the bead filling factor is suitably, for example, about 70 to 95 vol%.

Under such requirements, a person skilled in the art is able to set appropriate conditions by checking the particle morphology of the flake-shaped silver oxide particles described later.

Moreover, depending on the desired size of the flake-shaped silver oxide particles, the particles may be ground in two or more stages using beads that differ in, for example, bead size or type to gradually reduce their size. In addition, a known cooling or temperature control mechanism may be provided to prevent excessive temperature rise in the bead milling device or grinding chamber.

The amount of raw material silver oxide particles to be bead milled is not particularly limited as long as sufficient grinding can be achieved. For example, the amount may be 2 to 60 mass%, preferably 5 to 40 mass%, based on 100 mass% of the workpiece materials supplied to the grinding chamber of the bead milling device. Moreover, the amount of the dispersion medium may be, for example, 28 to 90 mass%, preferably 30 to 90 mass%, more preferably 60 to 88 mass%.

Moreover, although there are no particular limitations on the dispersant as long as the raw material silver oxide particles and the flake-shaped silver oxide particles can be dispersed, the amount of dispersant may be 8 to 70 mass%, preferably 10 to 70 mass%, more preferably 15 to 60 mass%, based on the amount of raw material silver oxide particles used.

In such a way, a slurry containing the flake-shaped silver oxide particles (hereinafter, sometimes referred to simply as "slurry") can be obtained, and the solids can be separated from the slurry and dried to obtain a silver oxide powder containing the flake-shaped silver oxide particles. Moreover, when a silver oxide paste composition (preferably, bonding composition) is to be subsequently prepared, the liquid in the slurry may be replaced to obtain a silver oxide paste, which will be described later, without performing the step of drying the solids.

The method for separating the solids is not particularly limited as long as it does not impair the various properties of the silver oxide powder. For example, it is convenient to separate the solids from the supernatant using a known centrifugation method. The method for drying the solids is not particularly limited as long as it causes no reduction of silver oxide. For example, after removal of the supernatant, the solids may be vacuum dried at room temperature to obtain a solid silver oxide powder. In order to purify the flake-shaped silver oxide particles and remove excess dispersant, the solids may be dispersed again in a new dispersion medium, and the same operation may be repeated. As another drying method, for example, a spray drying method may also be applied.

### (Composition (preferably, bonding composition) such as paste containing flake-shaped silver oxide particles)

A composition (e.g., a silver oxide paste according to the present disclosure) contains the flake-shaped silver oxide particles, dispersion medium, and dispersant described above. Such dispersion media or dispersants may be used alone or in combination of two or more.

As described above, the dispersant used during production adheres to the surfaces of the flake-shaped silver oxide particles and remains even after separation and drying of the solids. When the dispersant is a dispersant for a paste as described later, the composition (e.g., silver oxide paste) can be obtained by only adding a dispersion medium for a paste. Alternatively, the composition (e.g., silver oxide paste) may be obtained as a uniform dispersion, for example, by mixing a dispersion medium for a paste and, optionally, a dispersant for a paste with the silver oxide powder obtained by drying the slurry, and stirring the mixture.

When the composition (e.g., silver oxide paste) is prepared from the slurry without performing a drying step, the desired composition is preferably obtained by separating the slurry into solids and a supernatant by centrifugation, removing the supernatant, and adding a dispersion medium again to the resulting solids to redisperse the solids. Here, when using a dispersant different from that used during production, the desired dispersant and the dispersion medium may be added at the same time to perform replacement. The desired composition may also be prepared by repeating the processes of centrifugation, replacement with the dispersion medium and dispersant, redispersion, and the like multiple times. By adding a predetermined amount of a dispersion medium to the solids obtained after the above operation and stirring the mixture, a composition (e.g., silver oxide paste) containing the flake-shaped silver oxide particles can be prepared as uniform dispersion. Also, here, a dispersant may be further added as needed. As above, the composition (e.g., silver oxide paste) can be obtained as a uniform dispersion, and may be further stirred as necessary.

When the slurry is dried to obtain a silver oxide powder, the composition (e.g., silver oxide paste) can be obtained as a uniform dispersion, for example, by mixing at least the silver oxide powder with a dispersion medium for a paste, and stirring the mixture. In addition, any dispersant, dispersion medium, or the like may be further mixed as needed.

The stirring may be carried out using a known dispersing machine, kneading device, or other device used for paste or paint applications, under conditions that do not cause further grinding. Examples of such devices include various mixers, three-roll mills, and paint shakers.

Moreover, the flake-shaped silver oxide particles or the silver oxide powder containing the particles may be used after removing extremely large or small particles by a known classification process or the like.

### (Paste composition (preferably, bonding composition))

A paste composition (preferably, bonding composition) according to a suitable embodiment of the present disclosure is described below, though the present disclosure is not limited to the embodiment.

The paste preferably contains flake-shaped silver oxide particles, a compound having an ethylene-based or propylene-based glycol ether skeleton as a dispersion medium used to keep the flake-shaped silver oxide particles in a dispersed state, and a compound having a glycol ether skeleton in the main chain and/or side chain as a dispersant for dispersing the flake-shaped silver oxide particles.

Such a composition enables the paste to cause no reduction reaction at room temperature and to promote the reduction of silver oxide in a temperature range of 100°C to 150°C. Moreover, since no reduction reaction occurs at about room temperature (20°C to 30°C), the paste exhibits good pot life and can be used after storage for a certain period of time (for example, one month or more) following the preparation of the paste, without the need for immediate use after the preparation.

The amount of flake-shaped silver oxide particles contained in the composition needs not to be particularly limited as long as suitable coatability is exhibited during application. The suitable amount is, for example, 70 to 95 mass%, preferably 75 to 85 mass%, based on the total mass of the composition.

It is sufficient that the dispersion medium for a paste used for the paste is a compound that exhibits coatability suitable for application and has an ethylene-based or propylene-based glycol ether skeleton, and is volatile during the process of bonding. Suitable examples include diethylene glycol methyl ether (methyl carbitol), triethylene glycol methyl ether (methoxy triglycol), diethylene glycol methyl ether (carbitol), triethylene glycol methyl ether (ethoxy glycol), ethylene glycol propyl ether (propyl cellosolve), ethylene glycol monobutyl ether (butyl cellosolve), diethylene glycol monobutyl ether (butyl carbitol), triethylene glycol n-butyl ether (butoxy triglycol), ethylene glycol hexyl ether (hexyl cellosolve), diethylene glycol hexyl ether (hexyl carbitol), ethylene glycol n-butyl ether acetate (butyl cellosolve acetate), diethylene glycol n-butyl ether acetate (butyl carbitol acetate), ethylene glycol phenyl ether (Eph), propylene glycol methyl ether, dipropylene glycol methyl ether, tripropylene glycol methyl ether, propylene glycol n-propyl ether, dipropylene glycol n-propyl ether, propylene glycol n-butyl ether, dipropylene glycol n-butyl ether, tripropylene glycol n-butyl ether, propylene glycol methyl ether acetate, dipropylene glycol methyl ether acetate, propylene glycol diacetate, and propylene glycol phenyl ether. These may be used alone or in combination of two or more. Among these, diethylene glycol monobutyl ether is preferred.

The dispersion medium may be used in an amount of, for example, 8 to 30 mass%, preferably 10 to 25 mass%, more preferably 13 to 20 mass%, based on the total mass of the composition.

Here, when using two or more dispersion media, the amount means the total amount. The same applies to other similar descriptions.

The dispersant used for the paste may suitably be a compound having a glycol ether skeleton in the main chain and/or side chain. Any dispersant can be used without particular limitation, as long as it can keep the flake-shaped silver oxide particles in a dispersed state in a dispersion medium. Examples of such dispersants include polymer compounds having, in their main chain, a styrene, maleic acid, acrylic acid, methacrylic acid, aminoethyl methacrylate, or other skeleton, and having, in their side chain, a glycol ether polymer with a molecular weight of 100 or more. These may be used alone or in combination of two or more. The upper limit of the molecular weight of the dispersant may be, for example, 100000 or less. Moreover, the carboxyl group of maleic acid, acrylic acid, or methacrylic acid in the main chain may form a salt with an amine compound to adjust the acid value and amine value. Suitable examples of such polymer compounds include BYK-190, BYK-194N, and BYK-2055 as trade names (all manufactured by BYK).

The dispersant may be present in an amount of, for example, 12 mass% or less based on the total mass of the composition. It may preferably be used in an amount of 5 mass% or less, more preferably 3.5 mass% or less. Moreover, the lower limit of the amount is not particularly limited as long as dispersion can be achieved. For example, it may be 0.5 mass% or more, preferably 1 mass% or more, more preferably 2 mass% or more. When the amount of dispersant is 3.5 mass% or less based on the total mass of the composition, better bonding strength tends to be obtained.

In general, the reduction reaction of the silver oxide powder usually proceeds as follows.

### (1) Reduction of silver oxide → (2) Sintering of Ag → (3) Grain growth (bonding: sintering of Ag and grain growth)

Generally, silver oxide begins to decompose at about 200°C in the atmosphere, and its complete reduction to metallic silver is considered to require heating at 300°C or more.

When no reducing agent is incorporated, the reduction reaction of silver oxide ((1) → (2)) in the low temperature range of 250°C or less may proceed insufficiently, and unreduced silver oxide may remain in the bonding layer or sintered layer obtained after the process for (3). If unreduced silver oxide remains, the bonding strength, thermal conduction, and electrical conductivity may be adversely affected.

On the other hand, when a reducing agent is incorporated, the reduction reaction of silver oxide (1) can proceed sufficiently even in the low temperature range. However, in a system with a strong reducing effect, it is known that the reduction reaction (1) proceeds gradually even when the system is left standing at room temperature. It should be noted that, when the system is subjected to heat treatment for a certain period of time for drying or the like, the reaction proceeds to the stage (3) in the sequence (1) → (2) → (3), and it is considered difficult to stop the reaction at the reduction reaction stage.

In the invention described in Patent Literature 1, a strong reducing agent such as diethylene glycol is used to obtain a bonding layer having sufficient bonding strength. Here, if the coating layer obtained by applying such a paste is dried by heating, the reaction proceeds through the sequence (1) → (2) → (3). Accordingly, even when the semiconductor chip or substrate to be bonded is subsequently placed, the desired bonding may not be achieved. Therefore, bonding must be performed using the paste containing the reducing agent that has either not been dried by heating or has been dried insufficiently to remove the dispersion medium to such an extent that does not volatilize the reducing agent. The bonding layer obtained in this manner tends to contain more voids (air gaps) due to the volatilization of the dispersion medium and reducing agent during bonding, compared to a case where the coating layer has been dried. This may adversely affect the stability and other characteristics of the semiconductor device during repeated use. Furthermore, when a strong reducing agent such as diethylene glycol is present in the paste, reduction may proceed during the storage of the paste, disadvantageously making the paste unusable as a bonding material.

In a suitable embodiment of the present disclosure, no reducing agent is preferably present in the paste. By "no reducing agent being present in the paste", it is meant that no reducing agent is intentionally added to the paste, and even if a reducing agent is mixed in, the amount is 1 mass% or less, preferably 0.5 mass% or less.

The reducing agent is considered to be an organic substance having reducibility, which, in the present disclosure, is a polyhydric alcohol or an organic acid.

Examples of the polyhydric alcohol include ethylene glycol, diethylene glycol, glycerol, 2,5-dimethyl-2,5-hexanediol, 2,2-dimethyl-1,3-propanediol, 1,6-hexanediol, 1,2,6-hexanetriol, and 1,10-decanediol.

Examples of the organic acid include saturated fatty acids such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, and nonanedecanoic acid.

On the other hand, in the present disclosure, since the silver oxide used has a flake shape with a nano-sized thickness, it has been found to undergo the following sequence: (1) reduction of silver oxide → (2) precipitation of nano Ag → (3) sintering of nano Ag → (4) grain growth (bonding: sintering of Ag and grain growth), unlike the general reduction reaction of silver oxide shown above. The precipitation of nano Ag during the reduction allows sintering of Ag particles to proceed even in the low temperature range of 250°C or less, resulting in a higher bonding force.

In a suitable embodiment of the present disclosure, a protonic additive is preferably used instead of a known reducing agent for silver oxide. Although the use of a protonic additive facilitates the reduction reaction of silver oxide, the reduction reaction proceeds very slowly compared to when a reducing agent is used. Accordingly, it is possible to dry the paste by heating, and the dried coating layer may be used for bonding to, for example, a chip. Therefore, the bonding layer can contain fewer voids.

As described above, the paste preferably further contains a protonic additive. This allows the reduction reaction of silver oxide to proceed more easily, even when no reducing agent is incorporated, thereby reducing the amount of unreduced silver oxide in the bonding layer. Even though the presence of some unreduced silver oxide in the bonding layer has no significant effect on bonding strength, it may adversely affect thermal conduction and electrical conductivity. Furthermore, since it is possible to dry the paste by heating, the dried coating layer may be used for bonding to, for example, a chip, and the bonding layer can contain fewer voids.

An example of the reduction reaction of silver oxide using a protonic additive is described. For example, when water is used as a protonic additive, and diethylene glycol monobutyl ether (butyl carbitol) is used as a dispersion medium, the reduction reaction of silver oxide is presumed to proceed as follows. Thus, the presence of a protonic additive, such as water, is expected to allow the reduction reaction of silver oxide to proceed more easily.

### Redox reaction between butyl carbitol and silver oxide

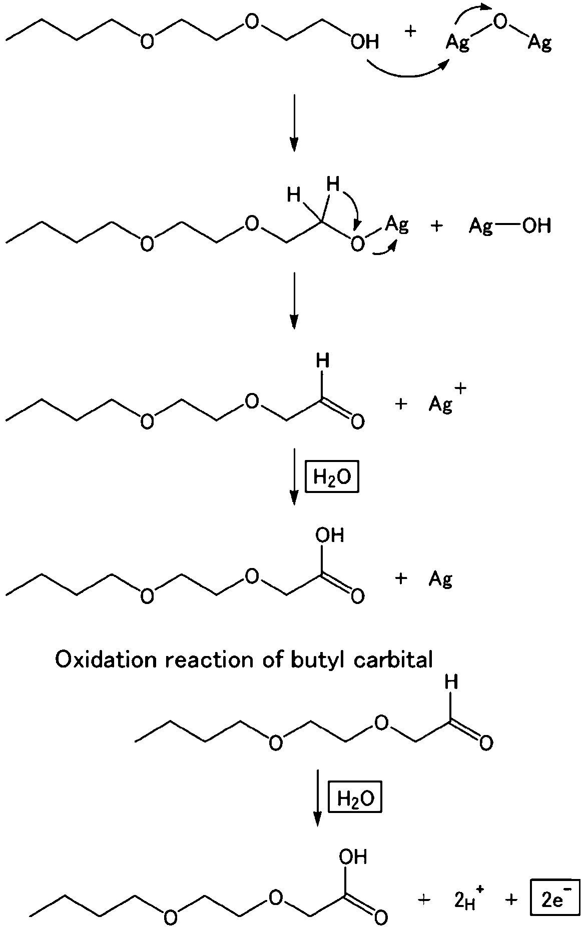

As described above, in the present disclosure, a compound having an ethylene-based or propylene-based glycol ether skeleton is preferably used as the dispersion medium used for the paste. When the dispersion medium (a compound having an ethylene-based or propylene-based glycol ether skeleton) is used together with the protonic additive, the aldehyde generated from the glycol ether during the reaction process may be oxidized to release electrons, thereby resulting in a tendency for the reduction reaction of silver oxide to proceed at a more moderate rate.

As the protonic additive, any protonic additive can be used without particular limitation as long as it can release a proton. Examples of such protonic additives include water, monohydric alcohols such as methanol and ethanol, and hydrogen peroxide water. These may be used alone or in combination of two or more. Among them, water is preferred.

The protonic additive may be used in an amount of, for example, 0.5 to 10 mass%, preferably 1 to 7 mass%, more preferably 3 to 6 mass%, based on the total mass of the composition.

For example, in the case where a composition is obtained by producing flake-shaped silver oxide particles by bead milling using water as a dispersion medium, separating the resulting slurry containing the flake-shaped silver oxide particles into solids and a supernatant by centrifugation, removing the supernatant, and adding a medium containing water as a dispersion medium again to the resulting solids to disperse the solids, the composition contains water serving as a protonic additive. Furthermore, in the case where a composition is obtained by producing the silver oxide particles by bead milling using water as a dispersion medium, separating the resulting slurry containing the flake-shaped silver oxide particles into solids and a supernatant by centrifugation, removing the supernatant, and adding a dispersion medium different from that used during production again to the resulting solids to replace the dispersion medium and disperse the solids in the dispersion medium different from that used during production, the composition contains water serving as a protonic additive because it is difficult to fully replace the dispersion medium contained in the original slurry.

On the other hand, in the case where a composition is obtained as a uniform dispersion, for example, by drying the slurry to obtain a silver oxide powder, mixing the silver oxide powder with a dispersion medium and a dispersant, and stirring the mixture, the dispersion medium contained in the original slurry has been removed.
Accordingly, a predetermined amount of a protonic additive is preferably added when it is not contained in the dispersion medium or dispersant for a paste used.

The composition may contain other optional components within a range that does not impair the various properties of the composition. For example, by using a known plasticizer (e.g., polyethylene glycol (PEG), dibutyl phthalate, or butyl benzyl phthalate), cracking and peeling during the reduction of silver oxide or during the drying of the paste can be more easily reduced with respect to flake-shaped silver oxide particles having a D50 of less than 200 nm.

In addition to the above, the composition may contain various fillers, known reducing agents, and other components within a range that does not impair the various properties of the composition. These may be used alone or in combination of two or more.

The combined amount of flake-shaped silver oxide particles, dispersant, and dispersion medium is preferably 90 mass% or more, more preferably 95 mass% or more, based on the total mass of the composition. This tends to lead to better bonding strength even when bonding at low temperatures.

The combined amount of flake-shaped silver oxide particles, dispersant, dispersion medium, and protonic additive is preferably 90 mass% or more, more preferably 95 mass% or more, based on the total mass of the composition. This tends to lead to better bonding strength even when bonding at low temperatures, and also tends to facilitate the reduction reaction of silver oxide.

The composition achieves good bonding strength even when bonding at low temperatures and is therefore suitable for use in bonding applications. In other words, the composition is preferably a bonding composition.

### (Method for bonding using silver oxide paste, and method for producing semiconductor device)

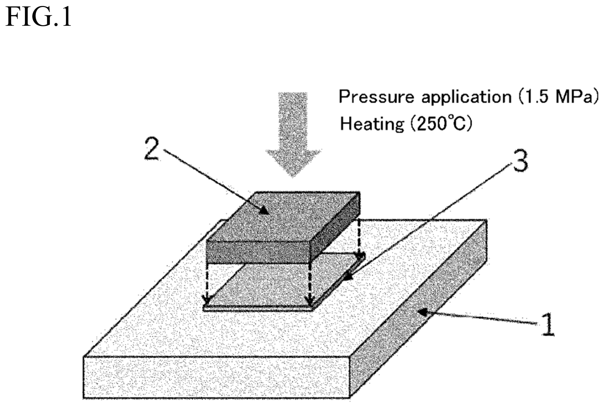

As shown in FIG. 1, the composition (preferably, bonding composition) thus obtained may be applied onto a substrate 1 and then dried by heating to form a layer for bonding 3, on which a semiconductor chip 2 may then be placed; subsequently, the substrate 1 and the semiconductor chip 2, with the layer for bonding 3 sandwiched therebetween, may be treated at a predetermined temperature under atmospheric pressure or increased pressure, whereby bonding between the bodies to be bonded can be achieved.

In the present disclosure, after applying the composition onto the first substrate and before placing, for example, the semiconductor chip as a second substrate, the composition layer is preferably dried. This can reduce air gaps (voids) in the bonding layer. Moreover, after applying the composition, the composition layer sandwiched between the substrate 1 and the semiconductor chip 2 may be directly heated and pressurized without drying the composition layer, as long as good bonding can be achieved. Moreover, although the following description refers to FIG. 1, the semiconductor chip 2 may be replaced by, for example, another optional substrate or a substrate to which the semiconductor chip 2 is bonded, serving as a second substrate. Likewise, the substrate 1, which is a semiconductor substrate, may be replaced by, for example, another optional substrate or a substrate to which the semiconductor chip 2 is bonded, serving as a first substrate.

The composition may be coated or applied to the substrate 1 by various printing methods. Suitable examples of such printing methods include screen printing, dispense coating, and applicator coating.

The composition is preferably used in an amount such that the thickness after drying is, for example, 10 to 100 µm, preferably 20 to 50 µm.

The composition may be dried at a temperature where the flake-shaped silver oxide particles are reduced and at or below a temperature where bonding is completed, for example, at a temperature of 80°C to 150°C, preferably 100°C to 120°C. Moreover, when the paste contains the protonic additive described above, sudden heat generation may temporarily occur within a temperature range of 100°C to 150°C, thereby facilitating the reduction reaction. Since the heat generation causes volatilization of the dispersion medium, the drying temperature may be taken as the temperature at which the reduction reaction occurs. Specifically, for example, the temperature is preferably 100°C to 150°C, and may be 100°C to 120°C.

The drying time is generally 10 minutes to 1 hour, and may be in the range of 20 minutes to 40 minutes, although it varies depending on the drying temperature employed.

In the layer for bonding 3 formed by drying the composition layer, at least some silver oxide has been reduced to silver and most of the dispersion medium has been removed. Moreover, some unreduced silver oxide may remain as long as it can be reduced by the time bonding is completed, and some of the dispersion medium may remain as long as it can be removed by the time bonding is completed.

It has also been found that if cracking or peeling occurs in the layer for bonding 3, voids derived from cracks, unbonded portions derived from peeling, or other defects tend to remain in the bonding layer after bonding. This is believed to be due to the low bonding temperature or low pressure during the production of a semiconductor device. Accordingly, in order to prevent cracking and peeling in the bonding layer, it is preferred to suppress cracking and peeling in the layer for bonding 3.

As the substrate, any substrate conventionally used in the preparation of semiconductor devices or power modules may be used. Suitable examples of such substrates include copper substrates, alumina, silicon nitride, aluminum nitride substrates, ceramic substrates, and various other heat dissipation substrates.

Moreover, as the semiconductor chip, any semiconductor chip conventionally employed may be used. Suitable examples of such semiconductor chips include semiconductor chips used in power semiconductors, such as Si semiconductor chips, SiC semiconductor chips, GaN semiconductor chips, and Ga₂O₃ semiconductor chips. Among these, SiC semiconductor chips are preferred.

The bonding pressure employed may be an appropriate bonding pressure within the range required for the production of power semiconductor devices. In particular, since the silver oxide powder of the present disclosure has excellent bonding properties, good bonding strength can be provided under lower pressures or temperatures.

The bonding pressure employed may be, for example, 0 to 30 MPa or 0 to 10 MPa, and, in particular, suitably about 0 to 5 MPa, more preferably 0.5 to 5 MPa.

Moreover, the bonding temperature employed may be an appropriate bonding temperature within the range required for the production of power semiconductor devices. The bonding temperature may be, for example, 300°C or less, preferably 250°C or less, more preferably 230°C or less, still more preferably 210°C or less. In the present disclosure, excellent bonding strength can be achieved even in a low temperature range close to 230°C. The lower limit of the temperature is not particularly limited as long as silver can be sintered. For example, it may be more than the temperature during drying, preferably 160°C or more, more preferably 180°C or more.

The resulting bonding layer is composed of metallic silver produced by reduction of silver oxide. With the composition (preferably, bonding composition) of the present disclosure, a bonding strength of 30 MPa or more can be achieved. It has also been found that, with the silver oxide powder of the present disclosure, the localized formation of voids in the bonding layer can be suppressed.

### (Regarding methods for measuring various properties)

### (1) Measurement of average major axis

The composition prepared as above is diluted by a factor of 1000 with butyl carbitol, and 1 ml of the resulting dilution is applied onto a smooth glass substrate (20 mm by 20 mm) by spin coating (rotation speed: 2000 rpm) and then vacuum dried at room temperature to obtain a deposit of flake-shaped silver oxide particles. Here, the flake-shaped silver oxide particles, when applied to, for example, a glass substrate, are deposited with the flat parts of the flake shape being oriented up and down due to their shape.

Next, the deposit is observed from above using a scanning electron microscope (SU-8220, manufactured by Hitachi High-Tech Corporation) to measure the major axes of 20 randomly selected particles. An average value is calculated from the measured values as the average major axis of the flake-shaped silver oxide particles. Here, the longest diagonal of a particle observed from above is taken as the major axis of the particle.

### (2) Measurement of average thickness

A volume of 1 ml of the composition prepared as above is applied onto a smooth glass substrate (20 mm by 20 mm) by screen printing and then vacuum dried at room temperature to obtain a deposit of flake-shaped silver oxide particles. Next, the glass substrate is cut at a position including the formed deposit to give a sample that can be observed from the cross-sectional direction of the flake-shaped silver oxide particles. Next, using a scanning electron microscope (SU-8220, manufactured by Hitachi High-Tech Corporation), the thicknesses of 20 randomly selected particles in the cross-section of the deposit are measured, and an average value is calculated from the measured values and taken as the average thickness of the flake-shaped silver oxide particles. Here, the distance between the upper and lower surfaces of the central part of each particle is taken as the thickness of the particle.

### (3) Measurement of D50

The term "D50 value" means the median diameter (median value) (based on scattering intensity in dynamic light scattering method) when individual particles are regarded as spheres, and is a statistical value at which half of the total flake-shaped silver oxide particles, or the total particles in the silver oxide powder containing the former particles, are present above the value and the remaining half are present below the value.

The D50 value is measured by diluting the composition prepared as above by a factor of 1000 with butyl carbitol and measuring the resulting dilution using a dynamic light scattering measuring device (Zetasizer Nano ZS, manufactured by Malvern Panalytical).

### (4) Powder X-ray Diffraction (XRD) measurement

The slurry prepared as above is centrifuged (centrifugal force: 20000×g) to separate it into solids and a supernatant. After removing the supernatant, the resulting solids are vacuum-dried at room temperature to obtain the dry silver oxide powder of the present disclosure.

The diffraction peaks of the dry powder are measured using a powder XRD measurement device (MINIFLEX 600, manufactured by Rigaku Corporation), and the half width is calculated from the resulting diffraction peaks by fitting the data of the main peak (32°) of the (111) plane of the flake-shaped silver oxide particles using a pseudo-Voigt function.

### (5) Cross-sectional observation of bonded body

The bonded body is embedded in a two-component curing-type epoxy resin, cured, and then cut, and the cut surface is optically polished to prepare a sample for observing the bonded cross-section. Next, the processed sample is subjected to cross-sectional observation using a scanning electron microscope (SU-8220, manufactured by Hitachi High-Tech Corporation). Cracking in the bonding layer is evaluated as × (Poor), Δ (Acceptable), or ∘ (Good), with × (Poor) indicating that significant cracking is observed, Δ (Acceptable) indicating that cracking is not considered significant but may reduce bonding strength or affect bonding stability, and ∘ (Good) indicating that no cracking is observed.

### (6) Detection of dispersant

The slurry prepared as above is centrifuged (centrifugal force: 20000×g) to separate it into solids and a supernatant. After removing the supernatant, the solids are vacuum dried at room temperature to obtain a dry silver oxide powder containing flake-shaped silver oxide particles. The dry powder is analyzed with a differential thermogravimetric/differential thermal analyzer (TG-DTA; Thermoplus TG8120, manufactured by Rigaku Corporation), and the amount of dispersant used (attached to silver oxide) is calculated from the mass loss rate.

### EXAMPLES

The present disclosure is described in further detail below with reference to examples and comparative examples, though the scope of the present disclosure is not limited at all the examples and comparative examples. Moreover, the following measured values were obtained using the measurement methods described above.

### (Example 1)

### - Preparation of flake-shaped silver oxide particles

The raw material silver oxide particles used as raw material were micro silver oxide (Silver Oxide PS, manufactured by DOWA Electronics) (spherical shape, particle size: 10 µm). The raw material silver oxide particles and water (dispersion medium) were mixed at a ratio of raw material silver oxide to water = 10:90 (mass ratio), and a dispersant (DISPERBYK-190 (a compound having a glycol ether skeleton in the main chain and/or side chain), manufactured by BYK) was further added in an amount of 30 mass% of the raw material silver oxide. The mixture was introduced into the grinding chamber of a bead milling device (Ultra Apex Mill UAM-015, manufactured by Hiroshima Metal & Machinery Co., Ltd.) and then ground to obtain a slurry containing flake-shaped silver oxide particles. In the grinding, the beads used were spheres made of zirconia (material) and having a diameter of 0.1 mm, and the grinding time was 200 minutes.

### - Preparation of silver oxide paste

The slurry containing flake-shaped silver oxide particles obtained in Example 1 was centrifuged (centrifugal force: 20000×g) to separate it into solids and a supernatant, and the supernatant was removed to remove excess dispersant and water. Next, butyl carbitol as a dispersion medium was supplied to the resulting solids to disperse the solids again. The dispersion was then centrifuged (centrifugal force: 20000×g) to separate it into solids and a supernatant, and the supernatant was removed, thereby replacing the water in the dispersion with butyl carbitol.

Butyl carbitol was incorporated into the resulting solids to obtain the composition shown in Table 1 below. The mixture was stirred using a planetary centrifugal mixer having no grinding function, and then dispersed using a three-roll mill to prepare a silver oxide paste containing flake-shaped silver oxide particles. Here, the water content in the silver oxide paste was measured by gas chromatography, and the water content in the silver oxide paste was 3 mass%.

### (Example 2)

A silver oxide paste was prepared in the same manner as in Example 1, except that in the production of a slurry containing flake-shaped silver oxide particles, a dispersant (DISPERBYK-190, manufactured by BYK) was added in an amount of 20 mass% of the raw material silver oxide, and the grinding time was set to 300 minutes.

### (Example 3)

A silver oxide paste was prepared in the same manner as in Example 2, except that in the production of a slurry containing flake-shaped silver oxide particles, the raw material silver oxide and water (dispersion medium) were mixed at a ratio of raw material silver oxide to water = 40:60 (weight ratio), and the grinding time was set to 315 minutes.

### (Example 4)

A slurry containing flake-shaped silver oxide particles was obtained in the same manner as in the production of a slurry containing flake-shaped silver oxide particles in Example 2. Next, a silver oxide paste was prepared in the same manner as in the paste preparation method of Example 1, except that in the incorporation of butyl carbitol into the solids obtained by centrifugation and solvent replacement, the dispersant was added so that the dispersant content in the paste was 4 mass%.

### (Example 5)

A silver oxide paste was prepared in the same manner as in Example 4, except that in the production of a slurry containing flake-shaped silver oxide particles, the dispersant was added so that the dispersant content in the paste was 11 mass%.

### (Example 6)

A slurry containing flake-shaped silver oxide particles was obtained in the same manner as in the production of a slurry containing flake-shaped silver oxide particles in Example 2. Next, the resulting slurry was introduced into a spray dryer (Mini Spray Dryer S-300, manufactured by Buchi Japan), and the dispersion medium was volatilized by heating to obtain a dry powder containing flake-shaped silver oxide particles.

Next, butyl carbitol was incorporated into the resulting dry powder to obtain the composition shown in Table 1 below. The mixture was stirred using a planetary centrifugal mixer having no grinding function, and then dispersed using a three-roll mill to prepare a silver oxide paste. No water was detected in the resulting silver oxide paste by gas chromatography measurement of the silver oxide paste.

### (Example 7)

A silver oxide paste was prepared in the same manner as in Example 6, except that in the production of a slurry containing flake-shaped silver oxide particles, water was incorporated into the resulting dry powder, in addition to butyl carbitol, to obtain the composition shown in Table 1 below. The water content in the resulting silver oxide paste was 2 mass% by gas chromatography measurement of the silver oxide paste.

### (Example 8)

A silver oxide paste was prepared in the same manner as in Example 7, except that in the production of a slurry containing flake-shaped silver oxide particles, water was added so that the water content in the paste was 3.5 mass%.

### (Example 9)

A silver oxide paste was prepared in the same manner as in Example 8, except that in the production of a slurry containing flake-shaped silver oxide particles, water was added so that the water content in the paste was 5 mass%.

### (Example 10)

A silver oxide paste was prepared in the same manner as in Example 8, except that in the production of a slurry containing flake-shaped silver oxide particles, water was added so that the water content in the paste was 7 mass %.

### (Example 11)

A silver oxide paste was prepared in the same manner as in Example 2, except that in the production of a slurry containing flake-shaped silver oxide particles, a dispersant (DISPERBYK-190, manufactured by BYK) was added in an amount of 20 mass% of the raw material silver oxide, and the grinding time was set to 360 minutes.

### (Example 12)

A silver oxide paste was prepared in the same manner as in Example 1, except that in the production of a slurry containing flake-shaped silver oxide particles, the dispersant used was DISPERBYK-194N (a compound having a glycol ether skeleton in the main chain and/or side chain) manufactured by BYK, and the grinding time was set to 270 minutes.

### (Example 13)

A silver oxide paste was prepared in the same manner as in Example 1, except that in the production of a slurry containing flake-shaped silver oxide particles, the dispersant used was DISPERBYK-2055 (a compound having a glycol ether skeleton in the main chain and/or side chain) manufactured by BYK, and the grinding time was set to 160 minutes.

### (Example 14)

### - Preparation of flake-shaped silver oxide particles

The silver oxide particles used as raw material were micro silver oxide (Silver Oxide PS, manufactured by DOWA Electronics) (spherical shape, particle size: 10 µm). The raw material silver oxide particles and water (dispersion liquid) were mixed at a ratio of raw material silver oxide to water = 10:90 (mass ratio), and a dispersant (DISPERBYK-190, manufactured by BYK) was further added in amount of 30 mass% of the raw material silver oxide. The mixture was introduced into the grinding chamber of a bead milling device (Ultra Apex Mill UAM-015, manufactured by Hiroshima Metal & Machinery Co., Ltd.) and then ground twice to obtain a slurry containing flakey silver oxide powder. Here, the grinding conditions were as follows. In the first grinding, the beads were spheres made of zirconia (material) and having a diameter of 0.1 mm, and the grinding time was 360 minutes. In the second grinding, the beads were spheres made of zirconia (material) and having a diameter of 0.05 mm, and the grinding time was 30 minutes.

### - Preparation of silver oxide paste

The slurry containing flake-shaped silver oxide particles obtained in Example 14 was centrifuged (centrifugal force: 20000×g) to separate it into solids and a supernatant, and the supernatant was removed to remove excess dispersant and water. Next, butyl carbitol as a dispersion medium was supplied to the resulting solids to disperse the solids again. The dispersion was then centrifuged (centrifugal force: 20000×g) to separate it into solids and a supernatant, and the supernatant was removed, thereby replacing the water in the dispersion with butyl carbitol.

Butyl carbitol and polyethylene glycol (PEG 400) as a plasticizer were incorporated into the resulting solids to obtain the composition shown in Table 1 below. The mixture was stirred using a planetary centrifugal mixer and then dispersed using a three-roll mill to prepare a silver oxide paste containing flake-shaped silver oxide particles.

### (Example 15)

A silver oxide paste was prepared in the same manner as in Example 7, except that in the production of a slurry containing flake-shaped silver oxide particles, a dispersant (DISPERBYK-190, manufactured by BYK) was added in an amount of 50 mass% of the raw material silver oxide, and the grinding time in the second grinding was set to 150 minutes.

### (Example 16)

### - Preparation of flake-shaped silver oxide particles

A slurry containing flake-shaped silver oxide particles was obtained in the same manner as in the production of a slurry containing flake-shaped silver oxide particles in Example 2.

### - Preparation of silver oxide paste

The slurry containing flake-shaped silver oxide particles obtained in Example 16 was centrifuged (centrifugal force: 20000×g) to separate it into solids and a supernatant, and the supernatant was removed to remove excess dispersant and water. Next, butyl carbitol as a dispersion medium was supplied to the resulting solids to disperse the solids again. The dispersion was then centrifuged (centrifugal force: 20000×g) to separate it into solids and a supernatant, and the supernatant was removed, thereby replacing the water in the dispersion with butyl carbitol. In order to further remove the residual water from the resulting solids, butyl carbitol was supplied to disperse the solids again. The dispersion was then centrifuged (centrifugal force: 20000×g) to separate it into solids and a supernatant, and the supernatant was removed.

Butyl carbitol was incorporated into the resulting solids to obtain the composition shown in Table 1 below. The mixture was stirred using a planetary centrifugal mixer having no grinding function, and then dispersed using a three-roll mill to prepare a silver oxide paste containing flake-shaped silver oxide particles. Here, the water content in the silver oxide paste was measured by gas chromatography, and the water content in the silver oxide paste was 1.7 mass%.

### (Example 17)

A silver oxide paste was prepared in the same manner as in Example 16, except that in the preparation of a paste as a bonding composition, the solvent replacement with butyl carbitol was repeated three times in total to further remove the residual water from the solids. Here, the water content in the silver oxide paste was measured by gas chromatography, and the water content in the silver oxide paste was 0.8 mass%.

### (Comparative Example 1)

A silver oxide paste was prepared in the same manner as in Example 1, except that in the production of a slurry containing flake-shaped silver oxide particles, a dispersant (DISPERBYK-190, manufactured by BYK) was added in an amount of 20 mass% of the raw material silver oxide, and the grinding time was set to 60 minutes.

### (Comparative Example 2)

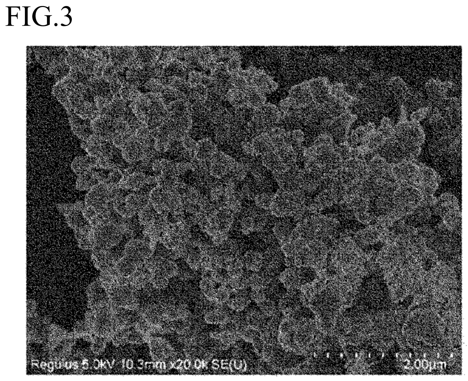

The silver oxide particles used were commercially available submicron-sized silver oxide particles (refer to FIG. 3 for shape). The silver oxide particles were mixed with water at a ratio of silver oxide particles to water = 10:90 (mass ratio), and a dispersant (DISPERBYK-190, manufactured by BYK) was further added in amount of 30 mass% of the silver oxide particles. The mixture was subjected to ultrasonic treatment for 280 minutes to obtain a slurry in which the silver oxide particles were uniformly dispersed.

The slurry was first centrifuged (centrifugal force: 20000×g) to separate it into solids and a supernatant, and the supernatant was removed, thereby removing excess dispersant and water. Through observation of an electron microscopic photograph of the silver oxide particles contained in the slurry, the initial aggregation shown in FIG. 3 was partially loosened, and all particles observed were spherical.

Butyl carbitol as a dispersion medium was supplied to the resulting solids to disperse the solids again. The dispersion was then centrifuged to separate it into solids and a supernatant, and the supernatant was removed, thereby replacing the residual water with butyl carbitol.

Butyl carbitol as a dispersion medium was incorporated into the resulting solids to obtain the composition shown in Table 1 below. The mixture was stirred using a planetary centrifugal mixer and then dispersed using a three-roll mill to prepare a paste.

### (Comparative Example 3)

The silver oxide particles used were commercially available submicron-sized silver oxide particles (refer to FIG. 3). The silver oxide particles were mixed with water at a ratio of silver oxide particles to water = 10:90 (mass ratio), and a dispersant (DISPERBYK-190, manufactured by BYK) was further added in amount of 30 mass% of the silver oxide particles. The mixture was dispersed for 5 minutes using a paint shaker (V-type, manufactured by Asada Iron Works Co., Ltd.) to partially loosen the aggregates of the silver oxide particles, thereby obtaining a slurry in which the silver oxide particles were uniformly dispersed. In the dispersion process, the beads were spheres made of zirconia (material) and having a diameter of 0.3 mm. The dispersion time was 5 minutes.

The slurry was first centrifuged (centrifugal force: 20000×g) to separate it into solids and a supernatant, and the supernatant was removed, thereby removing excess dispersant and water. Through observation of an electron microscopic photograph of the silver oxide particles contained in the slurry, the initial aggregation shown in FIG. 3 was loosened, and all particles observed were spherical.

Butyl carbitol as a dispersion medium was supplied to the resulting solids to disperse the solids again. The dispersion was then centrifuged to separate it into solids and a supernatant, and the supernatant was removed, thereby replacing the residual water with butyl carbitol.

Butyl carbitol as a dispersion medium was incorporated into the resulting solids to obtain the composition shown in Table 1 below. The mixture was stirred using a planetary centrifugal mixer and then dispersed using a three-roll mill to prepare a paste.

### (Comparative Example 4)

A paste was prepared in the same manner as in Comparative Example 3, except that in the production of a slurry containing silver oxide particles, the dispersion time with the paint shaker was set to 15 minutes. Moreover, through observation of the silver oxide particles contained in the resulting slurry using an electron microscope, the initial aggregation shown in FIG. 3 was loosened, and all particles observed were spherical.

### (Comparative Example 5)

A paste was prepared in the same manner as in Comparative Example 3, except that in the production of a slurry containing silver oxide particles, the dispersion time with the paint shaker was set to 30 minutes. Moreover, through observation of the silver oxide particles contained in the resulting slurry using an electron microscope, the initial aggregation shown in FIG. 3 was loosened, and all particles observed were spherical.

### (Comparative Example 6 and Comparative Example 7)

Flaky silver particles (average major axis: 6000 nm, average thickness: 100 nm) manufactured by Fukuda Metal, and butyl carbitol were mixed at a ratio of 90:10 (mass ratio) to prepare a paste.

The pastes obtained in the examples and comparative examples were subjected to a bonding test by the following method.

As shown in FIG. 1, a Cu substrate with Ni-Ag plating on the surface (outermost layer: Ag-plated layer, surface size: 20 mm by 20 mm, thickness: 3 mm) was provided, and the paste of each of the examples and comparative examples was applied onto the Ag-plated layer by screen printing, and then heated at 100°C for 30 minutes to remove the dispersion medium. It should be noted that, at that time, no cracking or peeling was visually observed in the dried layer for bonding.

Next, an Si chip (outermost layer: Ag-sputtered film, surface size: 3 mm by 3 mm, thickness: 625 µm) was placed on the dried layer for bonding such that its Ag-sputtered layer was in contact with the dried layer for bonding. Pressure (1.5 MPa) and heat (set temperature: 250°C) were applied from above for 4 minutes to convert the layer for bonding into a bonding layer, thereby bonding the Si chip to the Cu substrate.

### (cross-sectional observation)

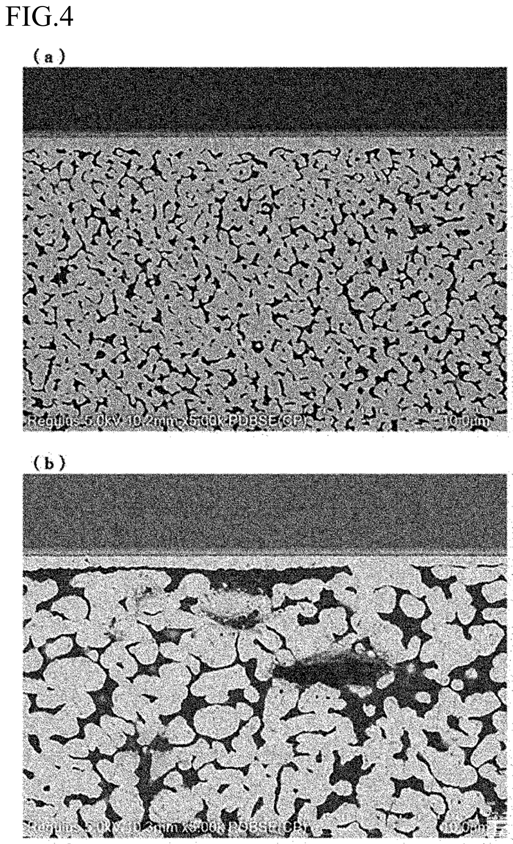

The cross-sections of the bonded bodies obtained in Examples 3 and 11 and Comparative Examples 6 and 7 were observed by the method described in the section "Regarding methods for measuring various properties". Cross-sectional photographs of the bonding layers in Example 3 and Comparative Example 6 are shown in FIG. 4.

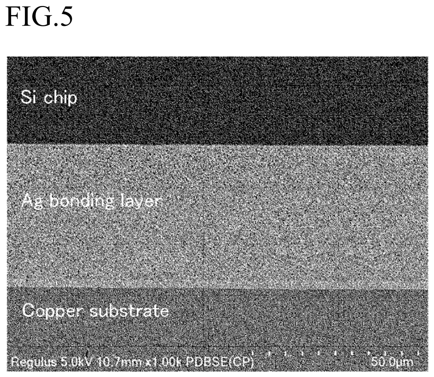

Furthermore, the cross-section of the bonded body obtained in Example 3 was observed by the method described in the section "Regarding methods for measuring various properties". A cross-sectional photograph of the bonding layer in Example 3 is shown in FIG. 5.

### (Bonding strength test)

The resulting bonded bodies were subjected to a die shear test (shearing) using a bond tester (DAGE 4000Plus, manufactured by DAGE Japan) to determine the bonding strength.

### (Reducibility after bonding)

The color of the peeled surface of the bonded body after the shear peeling in the bonding strength test was visually observed. Black color spots were considered as unreduced parts with silver oxide remaining, and silver-white color spots were considered as silver reduced from silver oxide. The reducibility after bonding was evaluated as × (Poor) or ∘ (Good), with × (Poor) indicating that even a part of the peeled surface was black, and ∘ (Good) indicating that the entire peeled surface was silver-white.

The properties of the silver oxide particles or metallic silver particles used in the examples and comparative examples, and the composition of the pastes containing these particles are shown in Table 1 below.

Also, regarding the pastes thus obtained, the bonding strength, reducibility after bonding, crack evaluation, and findings during bonding are indicated in Table 1 below. Note that the "BC content" in Table 1 represents the amount of diethylene glycol monobutyl ether.

**[Table 1]**

| | Silver oxide particles | | | | Paste composition | | | | | | | | Into paste | Various evaluations | | | | | |
|---|---|---|---|---|---|---|---|---|---|---|---|---|---|---|---|---|---|---|---|
| | Average major axis (nm) | Average thickness (nm) | D50 (nm) | Half width | Particle content (mass%) | Dispersant | | Dispersion medium | | | Others | | Process | Bonding conditions | | Bonding strength (MPa) | Reducibility after bonding | Crack evaluation | Note |
| | | | | | | Component or trade name | Content (mass%) | Component | Bc content (mass%) | Water content (mass%) | Component | Content (mass%) | | Pressure (MPa) | Temperature (° C) | | | | |
| Ex. 1 | 866 | 88 | 304 | 0.86 | 80 | BYK-190 | 3 | diethylene glycol monobutyl ether/water | 14 | 3 | | | centrifugation | 1.5 | 250 | 44 | ○ | ○ | |
| Ex. 2 | 486 | 28 | 247 | 0.98 | 80 | BYK-190 | 3 | diethylene glycol monobutyl ether/water | 14 | 3 | | | centrifugation | 1.5 | 250 | 62 | ○ | ○ | |
| Ex. 3 | 460 | 27 | 227 | 0.97 | 80 | BYK-190 | 3 | diethylene glycol monobutyl ether/water | 14 | 3 | | | centrifugation | 1.5 | 250 | 85 | ○ | ○ | |
| Ex. 4 | 591 | 33 | 233 | 0.97 | 79 | BYK-190 | 4 | diethylene glycol monobutyl ether/water | 14 | 3 | | | centrifugation | 1.5 | 250 | 38 | ○ | ○ | |
| Ex. 5 | 591 | 33 | 233 | 0.97 | 72 | BYK-190 | 11 | diethylene glycol monobutyl ether/water | 14 | 3 | | | centrifugation | 1.5 | 250 | 31 | ○ | ○ | |
| Ex. 6 | 591 | 33 | 233 | 0.97 | 80 | BYK-190 | 3 | diethylene glycol monobutyl ether/water | 17 | 0 | | | mixing with dry powder | 1.5 | 250 | 78 | × | ○ | |
| Ex. 7 | 591 | 33 | 233 | 0.97 | 80 | BYK-190 | 3 | diethylene glycol monobutyl ether/water | 15 | 2 | | | mixing with dry powder | 1.5 | 250 | 56 | ○ | ○ | |
| Ex. 8 | 591 | 33 | 233 | 0.97 | 80 | BYK-190 | 3 | diethylene glycol monobutyl ether/water | 13.5 | 3.5 | | | mixing with dry powder | 1.5 | 250 | 76 | ○ | ○ | |
| Ex. 9 | 591 | 33 | 233 | 0.97 | 80 | BYK-190 | 3 | diethylene glycol monobutyl ether/water | 12 | 5 | | | mixing with dry powder | 1.5 | 250 | 65 | ○ | ○ | |
| Ex. 10 | 591 | 33 | 233 | 0.97 | 80 | BYK-190 | 3 | diethylene glycol monobutyl ether/water | 10 | 7 | | | mixing with dry powder | 1.5 | 250 | 55 | ○ | ○ | |
| Ex. 11 | 454 | 27 | 222 | 0.97 | 80 | BYK-190 | 3 | diethylene glycol monobutyl ether/water | 14 | 3 | | | centrifugation | 1.5 | 230 | 59 | ○ | ○ | |
| Ex. 12 | 456 | 27 | 224 | 0.97 | 80 | BYK-194N | 3 | diethylene glycol monobutyl ether/water | 14 | 3 | | | centrifugation | 1.5 | 250 | 31 | ○ | ○ | |
| Ex. 13 | 456 | 27 | 224 | 0.97 | 80 | BYK-2055 | 3 | diethylene glycol monobutyl ether/water | 14 | 3 | | | centrifugation | 1.5 | 250 | 39 | ○ | ○ | |
| Ex. 14 | 407 | 24 | 186 | 1.00 | 79 | BYK-190 | 3 | diethylene glycol monobutyl ether/water | 9 | 3 | PEG400 | 6 | centr i fugat i on | 1.5 | 250 | 31 | ○ | ○ | |
| Ex. 15 | 351 | 22 | 143 | 1. 08 | 75 | BYK-190 | 3 | diethylene glycol monobutyl ether/water | 13 | 3 | PEG400 | 6 | centr i fugat i on | 1.5 | 250 | 67 | ○ | ○ | |
| Ex. 16 | 591 | 33 | 233 | 0.97 | 82.5 | BYK-190 | 2. 5 | diethylene glycol monobutyl ether/water | 13.3 | 1.7 | | | centr i fugat i on | 1.5 | 250 | 80 | ○ | ○ | |
| Ex. 17 | 591 | 33 | 233 | 0.97 | 83.5 | BYK-190 | 2. 5 | diethylene glycol monobutyl ether/water | 13.2 | 0.8 | | | centr i fugat i on | 1.5 | 250 | 85 | ○ | ○ | |
| Comp. Ex. 1 | 1270 | 119 | 371 | 0.77 | 80 | BYK-190 | 3 | diethylene glycol monobutyl ether/water | 14 | 3 | | | centr i fugat i on | 1.5 | 250 | 12 | × | ○ | poor reducibility, weak bonding strength |
| Comp. Ex. 2 | Not measured due to spherical shape | | 350 | 0.26 | 80 | BYK-190 | 3 | diethylene glycol monobutyl ether/water | 14 | 3 | | | centr i fugat i on | 1.5 | 250 | 10 | × | ○ | poor reducibility, weak bonding strength |
| Comp. Ex. 3 | Not measured due to spherical shape | | 338 | 0.28 | 80 | BYK-190 | 3 | diethylene glycol monobutyl ether/water | 14 | 3 | | | centr i fugat i on | 1.5 | 250 | 11 | × | ○ | poor reducibility, weak bonding strength |
| Comp. Ex. 4 | Not measured due to spherical shape | | 254 | 0.31 | 80 | BYK-190 | 3 | diethylene glycol monobutyl ether/water | 14 | 3 | | | centr i fugat i on | 1.5 | 250 | 17 | × | ○ | poor reducibility, weak bonding strength |
| Comp. Ex. 5 | Not measured due to spherical shape | | 233 | 0.33 | 80 | BYK-190 | 3 | diethylene glycol monobutyl ether/water | 14 | 3 | | | centrifugation | 1.5 | 250 | 13 | × | ○ | poor reducibility, weak bonding strength |
| Comp. Ex. 6 | 6000 | 100 | ND | ND | 90 | - | - | diethylene glycol monobutyl ether | 10 | - | | | mixing with dry powder | 1.5 | 250 | 38 | - | ○ | Fukuda Metal Micronflake Ag, voids present in film, poor printability with high thixotropy |
| Comp. Ex. 7 | 6000 | 100 | ND | ND | 90 | - | - | diethylene glycol monobutyl ether | 10 | - | | | mixing with dry powder | 1.5 | 230 | 21 | - | ○ | Fukuda Metal Micronflake Ag, voids present in film, poor printability with high thixotropy |

| | | | | | | | | | | | | | | | | | | | |
|---|---|---|---|---|---|---|---|---|---|---|---|---|---|---|---|---|---|---|---|
| Ex. : Example Comp. Ex. : Comparative Example | | | | | | | | | | | | | | | | | | | |

From Table 1, it was demonstrated that when the silver oxide paste of the present disclosure was used to bond the bodies to be bonded to each other, an excellent bonding strength of 30 MPa or more was obtained. In addition, the cross-sectional photograph of the bonding layer showed no cracking.

In contrast, as shown in Comparative Example 1, when the grinding time was short in the preparation of the flake-shaped silver oxide particles used, the D50 of the flake-shaped silver oxide particles was large, and the use of a paste containing such flake-shaped silver oxide particles resulted in low bonding strength. Also, when bonding was performed with a paste containing the spherical silver oxide particles used in any of Comparative Examples 2 to 5, it was demonstrated that the bonding strength was 20 MPa or less, which was significantly lower than those of the examples of the present disclosure, even though the D50 was within the range of the present disclosure. In addition, observation of the peeled surface after the bonding strength test showed unreduced silver oxide remaining.

Moreover, Example 6 containing no water had high bonding strength, but showed low reducibility as some unreduced silver oxide remained on the peeled surface after the bonding strength test.

Furthermore, as shown by Comparative Examples 6 and 7, when a paste containing commercially available flakey silver particles was used for bonding, the commercially available flakey silver particles had an average major axis of 6000 nm, i.e., a micron size, which resulted in the localized formation of voids at the bonding interface of the bonding layer and in the bonding layer. The localized formation of voids makes the bonding layer non-uniform, thereby tending to cause poor bonding stability. Although the mechanism of void formation is unknown, it is presumed that the voids may be caused by overlapping flakey silver particles having a large area, and cannot be eliminated at a low temperature of about 250°C.

As described above, the silver oxide paste of the present disclosure is useful for bonding a semiconductor substrate and a semiconductor chip with good bonding strength (without cracking).

### REFERENCE SIGNS LIST

1: substrate
2: semiconductor chip
3: layer for bonding containing flake-shaped silver oxide particles of the present disclosure

## Claims

1. Flake-shaped silver oxide particles or a silver oxide powder comprising the particles, the flake-shaped silver oxide particles having an average thickness of 1 to 100 nm and a D50 of 100 to 350 nm.

2. The flake-shaped silver oxide particles or silver oxide powder comprising the particles according to claim 1,
wherein the flake-shaped silver oxide particles have an average major axis of 300 to 1000 nm.

3. The flake-shaped silver oxide particles or silver oxide powder comprising the particles according to claim 1,
wherein a half width of a diffraction peak from a (111) plane in an X-ray diffraction spectrum of the flake-shaped silver oxide particles is 0.80 or more.

4. The flake-shaped silver oxide particles or silver oxide powder comprising the particles according to claim 1,
wherein at least some of the flake-shaped silver oxide particles have, on their surfaces, a compound having a glycol ether skeleton in a main chain, a side chain, or both.

5. A bonding composition, comprising:
the flake-shaped silver oxide particles or silver oxide powder comprising the particles according to any one of claims 1 to 4;
a dispersant; and
a dispersion medium.

6. The bonding composition according to claim 5,
wherein the dispersant is a compound having a glycol ether skeleton in a main chain, a side chain, or both.

7. The bonding composition according to claim 5,
wherein the dispersion medium is a compound having an ethylene-based or propylene-based glycol ether skeleton.

8. A method for producing the flake-shaped silver oxide particles or silver oxide powder comprising the particles according to claim 1, the method comprising subjecting silver oxide particles to bead mill grinding.

9. The method for producing the flake-shaped silver oxide particles or silver oxide powder comprising the particles according to claim 8,
wherein the bead mill grinding comprises:
supplying the silver oxide particles, the dispersant, and the dispersion medium to a bead mill grinding device; and
performing bead mill grinding in the device to obtain a slurry containing the flake-shaped silver oxide particles.

10. The method for producing the flake-shaped silver oxide particles or silver oxide powder comprising the particles according to claim 8 or 9,
wherein the dispersant is a compound having a glycol ether skeleton in a main chain, a side chain, or both.

11. A method for producing a semiconductor device, comprising:
(1) applying the bonding composition according to claim 5 onto a semiconductor substrate to form a layer of the bonding composition;
(2) placing a semiconductor chip on the layer of the bonding composition to form a stack; and
(3) heating the resulting stack at 300°C or less while applying a pressure of 0 to 30 MPa to integrate the stack.

12. The method for producing a semiconductor device according to claim 11, further comprising, between the steps (1) and (2), drying the layer of the bonding composition.

13. The method for producing a semiconductor device according to claim 11,
wherein the semiconductor chip is an SiC semiconductor chip.

14. A silver oxide paste, comprising:
flake-shaped silver oxide particles;
a dispersant; and
a dispersion medium,
wherein the silver oxide particles have an average thickness of 1 to 100 nm and a D50 of 100 to 350 nm.

15. The silver oxide paste according to claim 14, further comprising a protonic additive.

16. The silver oxide paste according to claim 14, wherein the dispersant is a compound having a glycol ether skeleton in a main chain, a side chain, or both.

17. The silver oxide paste according to claim 14,
wherein the dispersion medium is a compound having an ethylene-based or propylene-based glycol ether skeleton.

18. The silver oxide paste according to claim 14,
wherein the silver oxide particles have an average major axis of 300 to 1000 nm.

19. The silver oxide paste according to claim 14,
wherein a half width of a diffraction peak from a (111) plane in an X-ray diffraction spectrum of the silver oxide particles is 0.80 or more.

20. The silver oxide paste according to claim 14,
wherein an amount of the dispersant is 12 mass% or less based on a total mass of the silver oxide paste.

21. The silver oxide paste according to claim 15,
wherein an amount of the protonic additive is 0.5 to 10 mass% based on a total mass of the silver oxide paste.

22. The silver oxide paste according to claim 14 for use in a bonding application.

23. A method for producing a semiconductor device, comprising:
(1) applying the silver oxide paste according to any one of claims 14 to 22 onto a first substrate to form a layer of the silver oxide paste;
(2) placing a second substrate on the layer of the silver oxide paste to form a stack; and
(3) heating the resulting stack at 300°C or less while applying a pressure of 0 to 30 MPa to integrate the stack.

24. The method for producing a semiconductor device according to claim 23, further comprising, between the steps (1) and (2), drying the layer of the silver oxide paste.

25. The method for producing a semiconductor device according to claim 23,
wherein the second substrate is a semiconductor chip.
